# EUROPEAN PATENT SPECIFICATION

(11) **EP 1 737 068 B1**
(45) Date of publication and mention of the grant of the patent: **21.03.2018**
(21) Application number: 06010755.4
(22) Date of filing: 24.05.2006
(51) Int. Cl.: H01Q 1/40, H01Q 1/44, H04J 1/00, H04L 27/00

(54) **Wireless local area network communications module and integrated chip package**
WLAN-Modul und Schaltungschipverpackung
Module WLAN et boitier pour circuit intégré

(30) Priority: 21.06.2005 US 157286
(43) Date of publication of application: 27.12.2006
(73) Proprietor: Marvell World Trade Ltd., St. Michael 14027 (BB)
(72) Inventor: Janofsky, Eric B., Sunnyvale, CA 94085 (US)
(74) Representative: Grünecker Patent- und Rechtsanwälte PartG mbB

(56) References cited:
- US-A- 5 023 624
- US-A1- 2002 167 084
- US-A1- 2003 057 545
- US-A1- 2004 008 142
- US-A1- 2004 217 472
- US-A1- 2005 159 114
- PATENT ABSTRACTS OF JAPAN vol. 2003, no. 12, 5 December 2003 (2003-12-05) -& JP 2005 064581 A (FUJITSU TEN LTD), 10 March 2005 (2005-03-10)
- SERENI E ET AL: "A Software Radio OFDM Transceiver for WLAN applications" INTERNET CITATION, April 2001 (2001-04), XP002369287 INTERNET

## Description

### BACKGROUND

The present invention relates generally to devices for wireless communications. More particularly, the present invention relates to a wireless local area network communications module and integrated circuit package.

US 2002/167084 A1 discloses a structure and a method for fabricating a leadless chip carrier with an embedded antenna. The substrate has a top surface for receiving a semiconductor die and an antenna is patterned on the bottom surface of the substrate. The antenna is accessible by coupling it to a wire, and, through the wire, to a substrate signal bond pad and semiconductor die signal bond pad. The antenna traces according to this document are deposited on the bottom surface of the substrate.

US 2004/008142 A2 relates to a high gain integrated antenna and discloses an integrated circuit for wireless communications, which includes a substrate, at least one integrated antenna formed in or on the substrate, and a heat sink. At least one dielectric propagating layer is disposed between the integrated antenna and the heat sink. This document shows a completely integrated arrangement on a monolithic substrate. In particular, the antenna is deposited on an oxide layer in the form of a metallization structure.

US 5,023,624 relates to a package for a microwave circuit chip, wherein an associated microstrip antenna is formed of a multilayer ceramic laminate within which is supported a microwave chip carrier. On the outer surface of the ceramic laminate, the microstrip antenna is deposited.

US 2004/217472 A1 discloses several arrangements of chip carriers with integrated functions, such as antennae, EMI shields and heat sinks, which are formed by means of a conductive loaded resin-based material. The embodiments shown in figures 1 and 7 of this document are focused on a chip package, wherein the chip is mounted on a substrate and overmolded by an encapsulant, which has an opening that exposes a part of the metal interconnect structure. In a subsequent fabrication step, a conductive material is overmolded in order to provide an antenna structure. Figures 8 and 10 relate to an embodiment, wherein a flip chip circuit die is mounted on an interface layer of a substrate and is covered by an EMI shield being in contact with a lid of the casing. The embodiment of figure 11 refers to an arrangement, wherein the chip is wire bonded to the substrate, that is attached to a heat sink for cooling the circuit die. In this embodiment, the chip carrier also provides the heat sink functions for removing excess heat.

US 2003/057545 A1 refers to a PBGA substrate for anchoring a heat sink, wherein the circuit die is mounted on the substrate by means of wire bonding and wherein a heat sink is mounted to be in direct contact to the circuit die.

JP 2005 064581 A relates to OFDM demodulation and discloses that a plurality of OFDM demodulation sections, a plurality of demodulated signal interpolation processing sections, a demodulation combination section and a shared memory that are arranged within one package of a semiconductor circuit.

Sereni e et al.: "A Software Radio OFDM Transceiver for WLAN application", Internet citation, April 2001, generally relates to OFDM transceivers and the relevant IEEE standards.

In general, in one aspect, the invention features a device according to claim 1.

In general, in another aspect, the invention features a device according to claim 9.

The details of one or more implementations are set forth in the accompanying drawings and the description below. Other features will be apparent from the description and drawings, and from the claims.

### DESCRIPTION OF DRAWINGS

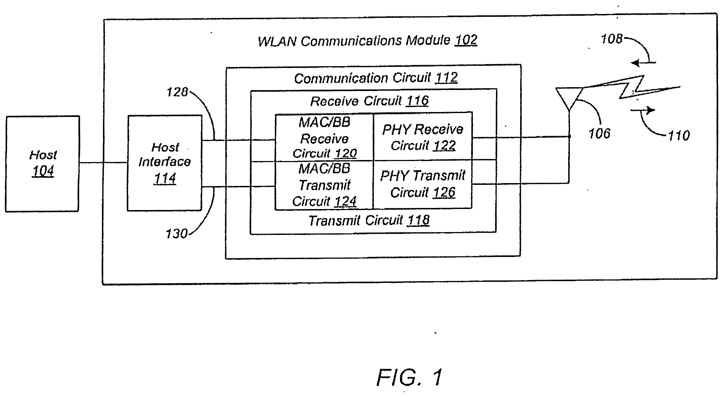

FIG 1 shows a WLAN communications module connected to a host such as a personal computer according to a preferred embodiment.

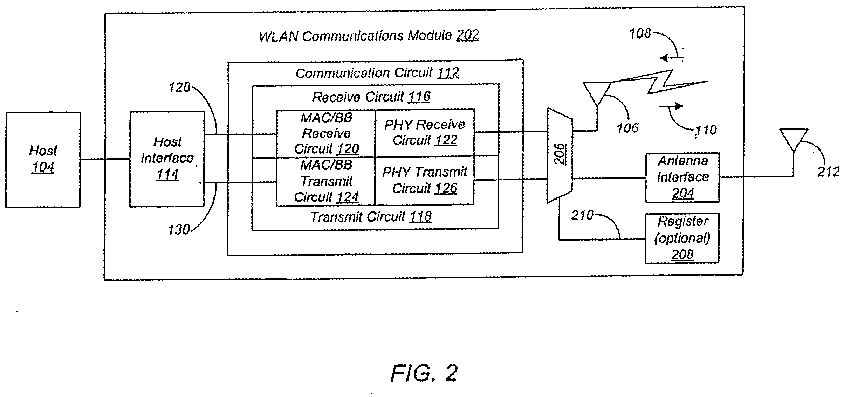

FIG 2 shows a WLAN communications module comprising an external antenna interface for connecting an external antenna according to a preferred embodiment.

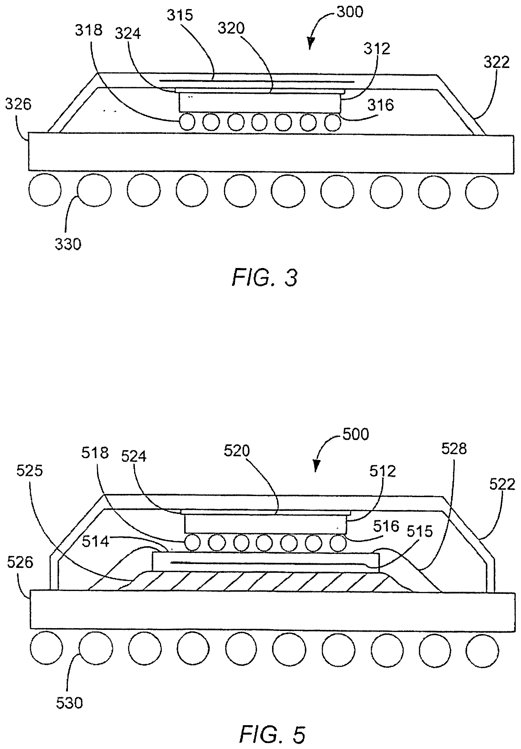

FIG. 3 shows an integrated circuit package comprising a heat sink comprising an antenna according to a preferred embodiment.

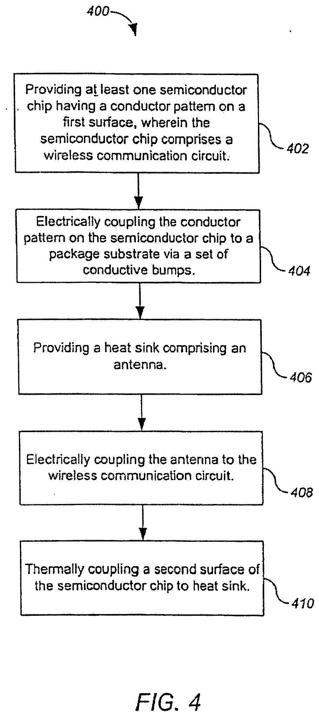

FIG. 4 shows a method of manufacturing an integrated circuit package comprising a heat sink comprising an antenna according to a preferred embodiment.
FIG 5 shows an integrated circuit package comprising an intermediate substrate comprising an antenna according to a preferred embodiment.

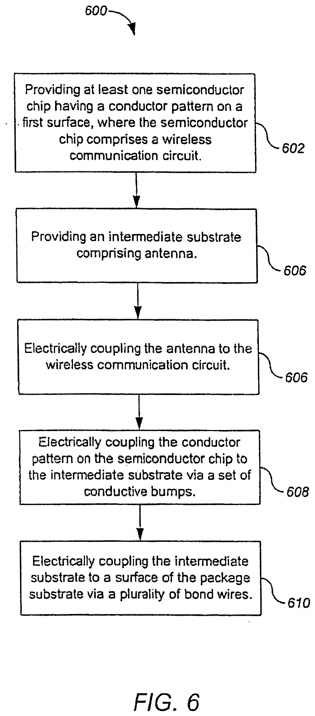

FIG. 6 shows a method of manufacturing an integrated circuit package comprising an intermediate substrate comprising an antenna according to a preferred embodiment.

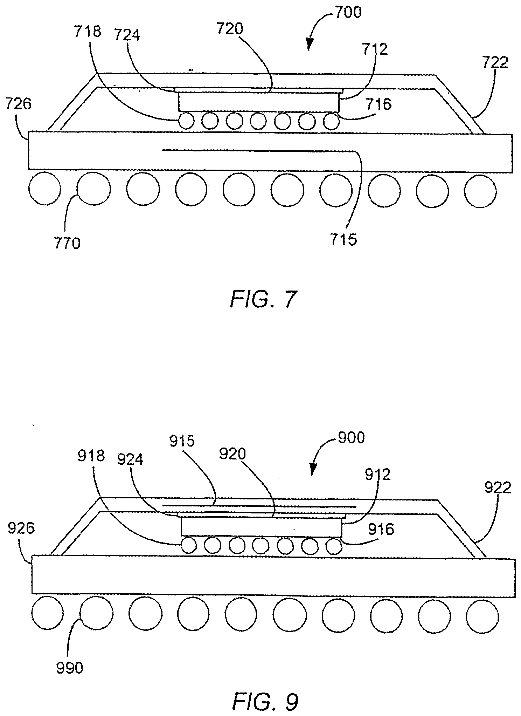

FIG 7 shows an integrated circuit package comprising a package substrate comprising an antenna according to a preferred embodiment.

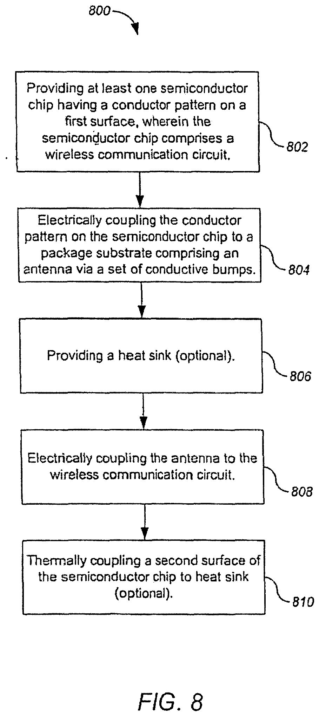

FIG. 8 shows a method of manufacturing an integrated circuit package comprising a package substrate comprising an antenna according to a preferred embodiment.
FIG 9 shows an integrated circuit package comprising a case comprising an antenna according to a preferred embodiment.

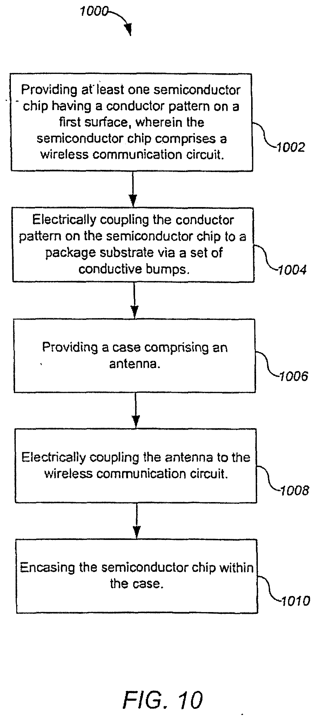

FIG 10 shows a method of manufacturing an integrated circuit package comprising a case comprising an antenna according to a preferred embodiment.

The leading digit(s) of each reference numeral used in this specification indicates the number of the drawing in which the reference numeral first appears.

### DETAILED DESCRIPTION

Embodiments of the present invention comprise a wireless local-area network (WLAN) communications module such as an orthogonal frequency-division multiplexing (OFDM) communications module comprising a host interface. The module can be fabricated, for example, as a PC card for use with a laptop computer. Other embodiments of the module employ other implementations.

FIG. 1 shows a WLAN communications module 102 connected to a host 104 such as a personal computer according to a preferred embodiment. Module 102 comprises an antenna 106 to receive radio-frequency (RF) signals 108 and to transmit RF signals 110, a communication circuit 112, and a host interface 114 to communicate with host 104, which are preferably arranged on a printed circuit board.

Communication circuit 112 comprises a receive circuit 116 to produce digital data 128 based on RF signals 108, and a transmit circuit 118 to produce RF signals 110 based on digital data 130 received from host 104 over host interface 114. Communication circuit 112 provides digital data 128 to host 104 over host interface 114. Receive circuit 116 preferably comprises a media access controller and baseband (MAC/BB) receive circuit 120 and a physical-layer device (PHY) receive circuit 122 that operate according to well-known techniques. Transmit circuit 118 preferably comprises a MAC/BB transmit circuit 124 and a PHY transmit circuit 126 that operate according to well-known techniques. In some embodiments, module 102 is compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

FIG. 2 shows a WLAN communications module 202 comprising an external antenna interface 204 for connecting an external antenna according to a preferred embodiment. Elements 106-130 of module 202 are as described above for communications module 102 of FIG. 1. However, module 202 also includes external antenna interface 204, a switch 206 and an optional memory such as a register 208. External antenna interface 204 can be implemented as a connector that allows an external antenna 212 to be connected to module 202. Switch 206 provides a signal path for RF signals 108, 110 between communication circuit 112 and either antenna 106 or external antenna interface 204 in accordance with a control signal 210. Control signal 210 can be generated in any number of ways. For example, control signal 210 can be provided directly to switch 206 by host 104 over host interface 114, can be stored as a flag in optional register 208, or can be provided by antenna interface 204 on detecting an external antenna 212. In some embodiments, module 202 is compliant with one or more of IEEE standards 802.11, 802.11a, 802.11b, 802.11g, 802.11n, 802.16, and 802.20, other regional and national standards, and the like.

In some embodiments, host interface 114 complies with at least one specification selected from the group comprising complies with at least one specification selected from the group comprising Peripheral Component Interconnect (PCI); PCI Express; Mini PCI; PC card; Universal Serial Bus; and Firewire. Other embodiments employ other specifications for host interface 114.

Embodiments of the present invention comprise an integrated circuit package and method for forming the same, where the integrated circuit package comprises an antenna and at least one integrated circuit preferably implemented in a flip chip ball grid array (FCBGA). In a FCBGA, the integrated circuit is generally connected to a package substrate via solder balls. The package substrate is coupled to the circuit board through solder balls on the underside of the package. Embodiments of the integrated circuit package can be used in embodiments of the communications module to house the communication circuit therein.

FIG. 3 shows an integrated circuit package 300 comprising a heat sink 322 comprising an antenna 315 according to a preferred embodiment. Integrated circuit package 300 is preferably a FCBGA that can dissipate heat through heat sink 322. In addition, the thermal path of integrated circuit package 300 extends away from the circuit board to reduce the heat load on the circuit board. But while embodiments of the present invention are described in terms of FCBGAs, embodiments of the present invention are not limited to FCBGAs, and can be implemented using any other integrated circuit packaging technologies which currently exist or are under development.

Heat sink 322 comprises one or more antennas 315, which can be attached on a surface of heat sink 122 or formed within heat sink 122. In some embodiments, heat sink 315 is an antenna. To accommodate size restrictions imposed by the size of heat sink 322, antenna 315 can have a length that is a vulgar fraction of a wavelength of the signals transmitted and received by antenna 315. A vulgar fraction consists of one integer divided by a non-zero integer, as is well-known in the relevant arts.

Integrated circuit package 300 includes a integrated circuit 312 configured for flip chip mounting. Integrated circuit 312 preferably comprises communications circuits for transmitting and/or receiving data over antenna 315. For example, integrated circuit 312 can comprise a communication circuit comprising a receive circuit to produce first digital data based on first RF signals received by antenna 315, and a transmit circuit to produce second RF signals based on second digital data, wherein the second RF signals are transmitted by antenna 315. The communications circuit can comprise a media access controller/baseband circuit (MAC/BB) and a physical-layer device (PHY) that is electrically connected to antenna 315. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 316 of the integrated circuit 312 is electrically connected to the package substrate 326 via conductive bumps 318. The conductive bumps 318 may be formed from any electrically conductive material such as Pb/Sn solder, Au, Ag, alloys of Au and Ag, and metallic coated polymeric studs. In addition, an epoxy or other suitable material formed between the conductive bumps 318 may be used as an embedding material for the conductive bumps 318 to provide mechanical support and moisture protection. The integrated circuit 312 may be attached to the package substrate 326 using any flip chip compatible bonding method such as thermocompression, soldering, encapsulation, and adhesives.

The other surface 320 of the integrated circuit 312 is attached to a heat sink 322 for coupling heat away from the integrated circuit 312. The heat sink 322 may be made of any thermally conductive material such as copper and thermally conductive plastic. The integrated circuit 312 may be attached to the heat sink 322 by any attachment item 324 that does not thermally isolate the integrated circuit 312 such as adhesive, solder, and press-fitting by applying a mechanical force to the first surface of the integrated circuit 312 or the package substrate 326. For example, a thermally conductive epoxy may be used as the attachment item 324.

Package substrate 326 may be made of any substrate material suitable for ball grid array mounting to a device such as a circuit board or substrate. A plurality of conductive bumps 330 are provided for connecting integrated circuit package 300 to a circuit board or the like.

The number of integrated circuits 312 in integrated circuit package 300 according to embodiments of the present invention is not limited to one. Any practical number of integrated circuits 312 can be implemented within a single integrated circuit package 300 to form a multichip module (MCM). For example, an integrated circuit package 300 can include two integrated circuits 312 where one of the integrated circuits 312 comprises a MAC/BB and the other comprises a PHY.

FIG 4 shows a method 400 of manufacturing an integrated circuit package 300 comprising a heat sink 322 comprising an antenna 315 according to a preferred embodiment. Method 400 comprises providing at least one integrated circuit 312 having a conductor pattern on a first surface, wherein integrated circuit 312 comprises a wireless communication circuit (step 402), electrically coupling the conductor pattern on integrated circuit 312 to a package substrate 326 via a set of conductive bumps 318 (step 404), providing a heat sink 322 comprising an antenna 315 (step 406), electrically coupling antenna 315 to the wireless communication circuit (step 408), and thermally coupling a second surface 320 of integrated circuit 312 to heat sink 322 (step 410).

FIG. 5 shows an integrated circuit package 500 comprising an intermediate substrate 514 comprising an antenna 515 according to a preferred embodiment. Integrated circuit package 510 is preferably a modified FCBGA that can optionally dissipate approximately the same amount of heat as a conventional flip chip package at a much lower cost with the addition of optional heat sink 522. In addition, the thermal path of integrated circuit package 500 extends away from the circuit board to reduce the heat load on the circuit board. But while embodiments of the present invention are described in terms of FCBGAs, embodiments of the present invention are not limited to FCBGAs, and can be implemented using any other integrated circuit packaging technologies which currently exist or are under development.

Integrated circuit package 500 includes a integrated circuit 512 configured for flip chip mounting that is attached to an intermediate substrate 514 that comprises one or more antennas 515 that can be formed, for example, by etching intermediate substrate 514. To accommodate size restrictions imposed by the size of intermediate substrate 514, antenna 515 can have a length that is a vulgar fraction of a wavelength of the signals transmitted and received by antenna 515.

Integrated circuit 512 preferably comprises communications circuits for transmitting and/or receiving data over antenna 515. For example, integrated circuit 512 can comprise a communication circuit comprising a receive circuit to produce first digital data based on first RF signals received by antenna 515, and a transmit circuit to produce second RF signals based on second digital data, wherein the second RF signals are transmitted by antenna 515. The communications circuit can comprise a media access controller and baseband (MAC/BB) and a physical-layer device (PHY) that is electrically connected to antenna 515. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 516 of the integrated circuit 512 is electrically connected to the intermediate substrate 514 via conductive bumps 518. The conductive bumps 518 may be formed from any electrically conductive material such as Pb/Sn solder, Au, Ag, alloys of Au and Ag, and metallic coated polymeric studs. In addition, an epoxy or other suitable material formed between the conductive bumps 518 may be used as an embedding material for the conductive bumps 518 to provide mechanical support and moisture protection. The integrated circuit 512 may be attached to the intermediate substrate 514 using any flip chip compatible bonding method such as thermocompression, soldering, encapsulation, and adhesives.

In some embodiments, the other surface 520 of the integrated circuit 512 is attached to an optional heat sink 522 for coupling heat away from the integrated circuit 512. The heat sink 522 may be made of any thermally conductive material such as copper and thermally conductive plastic. The integrated circuit 512 may be attached to the heat sink 522 by any attachment item 524 that does not thermally isolate the integrated circuit 512 such as adhesive, solder, and press-fitting by applying a mechanical force to the first surface of the integrated circuit 512 or the intermediate substrate 514. For example, a thermally conductive epoxy may be used as the attachment item 524.

The intermediate substrate 514 is electrically connected to conductors on a package substrate 526 via several bonding wires 528. The intermediate substrate 514 converts flip chip mounting of the integrated circuit 512 into wire bond mounting to combine and exceed the advantages of FCBGA and PBGA. Similar to FCBGA, the integrated circuit package 500 provides a low resistance thermal path for heat generated in the integrated circuit 512 so that power dissipation may be accommodated. In addition, the thermal path of the integrated circuit package 500 extends to the heat sink 522, away from the package substrate 526, thereby reducing the heat load of the circuit board or circuit substrate to which the integrated circuit package 500 is connected. Also, the integrated circuit package may employ a substrate that is as inexpensive as substrates used for PBGA packages. Additionally, using the intermediate substrate 514 reduces the wiring pitch requirements on bonding wire equipment used for attaching the bonding wires 528.

Package substrate 526 may be made of any substrate material suitable for ball grid array mounting to a device such as a circuit board or substrate. Additionally, a support layer 525 such as an epoxy or other suitable material may be inserted between intermediate substrate 514 and package substrate 526 to provide addition mechanical support. A plurality of conductive bumps 530 are provided for connecting integrated circuit package 500 to a circuit board or the like.

The number of integrated circuits 512 in integrated circuit package 500 according to embodiments of the present invention is not limited to one. Any practical number of integrated circuits 512 can be implemented within a single integrated circuit package 500 to form a multichip module (MCM). For example, an integrated circuit package 500 can include two integrated circuits 512 where one of the integrated circuits 512 comprises a MAC/BB and the other comprises a PHY. Furthermore, while embodiments of the present invention are described in terms of FCBGAs, other embodiments are not limited to FCBGAs, and can be implemented using any other integrated circuit packaging technologies which currently exist or are under development.

FIG 6 shows a method 600 of manufacturing an integrated circuit package 500 comprising an intermediate substrate 514 comprising an antenna 515 according to a preferred embodiment. Method 600 comprises providing at least one integrated circuit 512 having a conductor pattern on a first surface, wherein integrated circuit 512 comprises a wireless communication circuit (step 602), providing an intermediate substrate 514 comprising an antenna 515 (step 604), electrically coupling antenna 515 to the wireless communication circuit (step 606), electrically coupling the conductor pattern on integrated circuit 512 to intermediate substrate 514 via a set of conductive bumps 518 (step 608), and electrically coupling intermediate substrate 514 to a surface of package substrate 526 via a plurality of bond wires 528 (step 610).

FIG 7 shows an integrated circuit package 700 comprising a package substrate 726 comprising an antenna 715 according to a preferred embodiment. Integrated circuit package 700 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Package substrate 726 comprises one or more antennas 715, which can be attached on a surface of package substrate 726 or formed within package substrate 726. To accommodate size restrictions imposed by the size of package substrate 726, antenna 715 can have a length that is a vulgar fraction of a wavelength of the signals transmitted and received by antenna 715. A vulgar fraction consists of one integer divided by a non-zero integer, as is well-known in the relevant arts.

Integrated circuit package 700 includes a integrated circuit 712 configured for flip chip mounting. Integrated circuit 712 preferably comprises communications circuits for transmitting and/or receiving data over antenna 715. For example, integrated circuit 712 can comprise a communication circuit comprising a receive circuit to produce first digital data based on first RF signals received by antenna 715, and a transmit circuit to produce second RF signals based on second digital data, wherein the second RF signals are transmitted by antenna 715. The communications circuit can comprise a media access controller/baseband circuit (MAC/BB) and a physical-layer device (PHY) that is electrically connected to antenna 715. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 716 of the integrated circuit 712 is electrically connected to the package substrate 726 via conductive bumps 718. The conductive bumps 718 may be formed from any electrically conductive material such as Pb/Sn solder, Au, Ag, alloys of Au and Ag, and metallic coated polymeric studs. In addition, an epoxy or other suitable material formed between the conductive bumps 718 may be used as an embedding material for the conductive bumps 718 to provide mechanical support and moisture protection. The integrated circuit 712 may be attached to the package substrate 726 using any flip chip compatible bonding method such as thermocompression, soldering, encapsulation, and adhesives.

The other surface 720 of the integrated circuit 712 is optionally attached to a beat sink 722 for coupling heat away from the integrated circuit 712. Optional heat sink 722 may be made of any thermally conductive material such as copper and thermally conductive plastic. The integrated circuit 712 may be attached to the heat sink 722 by any attachment item 724 that does not thermally isolate the integrated circuit 712 such as adhesive, solder, and press-fitting by applying a mechanical force to the first surface of the integrated circuit 712 or the package substrate 726. For example, a thermally conductive epoxy may be used as the attachment item 724.

Package substrate 726 may be made of any substrate material suitable for ball grid array mounting to a device such as a circuit board or substrate. A plurality of conductive bumps 730 are provided for connecting integrated circuit package 700 to a circuit board or the like.

The number of integrated circuits 712 in integrated circuit package 700 according to embodiments of the present invention is not limited to one. Any practical number of integrated circuits 712 can be implemented within a single integrated circuit package 700 to form a multichip module (MCM). For example, an integrated circuit package 700 can include two integrated circuits 712 where one of the integrated circuits 712 comprises a MAC/BB and the other comprises a PHY.

FIG 8 shows a method 800 of manufacturing an integrated circuit package 700 comprising a package substrate 726 comprising an antenna 715 according to a preferred embodiment. Method 800 comprises providing at least one integrated circuit 712 having a conductor pattern on a first surface, wherein integrated circuit 712 comprises a wireless communication circuit (step 802), electrically coupling the conductor pattern on integrated circuit 712 to a package substrate 726 comprising an antenna 715 via a set of conductive bumps 718 (step 804), providing optional heat sink 722 (step 806), electrically coupling antenna 715 to the wireless communication circuit (step 808), and optionally thermally coupling a second surface 720 of integrated circuit 712 to optional heat sink 722 (step 810).

FIG 9 shows an integrated circuit package 900 comprising a case 922 comprising an antenna 915 according to a preferred embodiment. Case 922 can be made of plastic, ceramic, or any other material, as is well-known in the relevant arts. Integrated circuit package 900 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Case 922 comprises one or more antennas 915, which can be attached on a surface of case 122 or formed within case 122. To accommodate size restrictions imposed by the size of case 922, antenna 915 can have a length that is a vulgar fraction of a wavelength of the signals transmitted and received by antenna 915. A vulgar fraction consists of one integer divided by a non-zero integer, as is well-known in the relevant arts.

Integrated circuit package 900 includes a integrated circuit 912 configured for flip chip mounting. Integrated circuit 912 preferably comprises communications circuits for transmitting and/or receiving data over antenna 915. For example, integrated circuit 912 can comprise a communication circuit comprising a receive circuit to produce first digital data based on first RF signals received by antenna 915, and a transmit circuit to produce second RF signals based on second digital data, wherein the second RF signals are transmitted by antenna 915. The communications circuit can comprise a media access controller/baseband circuit (MAC/BB) and a physical-layer device (PHY) that is electrically connected to antenna 915. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 916 of the integrated circuit 912 is electrically connected to the package substrate 926 via conductive bumps 918. The conductive bumps 918 may be formed from any electrically conductive material such as Pb/Sn solder, Au, Ag, alloys of Au and Ag, and metallic coated polymeric studs. In addition, an epoxy or other suitable material formed between the conductive bumps 918 may be used as an embedding material for the conductive bumps 918 to provide mechanical support and moisture protection. The integrated circuit 912 may be attached to the package substrate 926 using any flip chip compatible bonding method such as thermocompression, soldering, encapsulation, and adhesives. Antenna 915 can be electrically coupled to integrated circuit 912 by conductive bumps 918, by other conventional types of interconnects, or by a special-purpose interconnect provided especially for antenna 915.

Package substrate 926 may be made of any substrate material suitable for ball grid array mounting to a device such as a circuit board or substrate. A plurality of conductive bumps 930 are provided for connecting integrated circuit package 900 to a circuit board or the like.

The number of integrated circuits 912 in integrated circuit package 900 according to embodiments of the present invention is not limited to one. Any practical number of integrated circuits 912 can be implemented within a single integrated circuit package 900 to form a multichip module (MCM). For example, an integrated circuit package 900 can include two integrated circuits 912 where one of the integrated circuits 912 comprises a MAC/BB and the other comprises a PHY.

FIG 10 shows a method 1000 of manufacturing an integrated circuit package 900 comprising a case 922 comprising an antenna 915 according to a preferred embodiment. Method 1000 comprises providing at least one integrated circuit 912 having a conductor pattern on a first surface, wherein integrated circuit 912 comprises a wireless communication circuit (step 1002), electrically coupling the conductor pattern on integrated circuit 912 to a package substrate 926 via a set of conductive bumps 918 (step 1004), providing a case 922 comprising an antenna 915 (step 1006), electrically coupling antenna 915 to the wireless communication circuit (step 1008), and encasing integrated circuit 912 within case 922 (step 1010).

## Claims

1. An integrated circuit package for being connected to a circuit board comprising:
at least one integrated circuit (712) comprising a wireless communication circuit comprising
an orthogonal frequency-division multiplexing, OFDM, demodulator to produce first digital data based on first OFDM signals, and
an OFDM modulator to produce second OFDM signals based on second digital data; and
a package substrate (726) electrically coupled to the at least one integrated circuit, the package substrate comprising an antenna (715) to receive the first OFDM signals, and to transmit the second OFDM signals, the antenna being formed within the package substrate and being electrically coupled to the wireless communication circuit.

2. The integrated circuit package of claim 1, wherein the package substrate is electrically coupled via conductive bumps to a surface of the at least one integrated circuit.

3. A flip chip ball grid array package comprising the integrated circuit package of claim 1.

4. The integrated circuit package of claim 1, wherein the at least one integrated circuit comprises: a first integrated circuit comprising a media access controller and baseband circuit; and a second integrated circuit comprising a physical-layer device.

5. The integrated circuit package of claim 1, wherein the wireless communication circuit comprises:
a receive circuit to produce first baseband signals based on first RF signals received by the antenna; and
a transmit circuit to produce second RF signals based on second baseband signals, wherein the second RF signals are transmitted by the antenna.

6. The integrated circuit package of claim 5, wherein the first baseband signals comprise first digital data; and
wherein the second baseband signals comprise second digital data.

7. The integrated circuit package of claim 5, wherein the antenna has a length that is a vulgar fraction of a wavelength of the first and second RF signals.

8. The integrated circuit package of claim 1, wherein the wireless communication circuit is compliant with at least one standard selected from the group consisting of IEEE standards 802.11, 802.11a, 802.11b, 802.11g, 802.11n, 802.16, and 802.20.

9. An integrated circuit package comprising:
at least one integrated circuit (912) comprising a wireless communication circuit comprising
an orthogonal frequency-division multiplexing, OFDM, demodulator to produce first digital data based on first OFDM signals, and
an OFDM modulator to produce second OFDM signals based on second digital data; and
a case (922) comprising an antenna (915) to receive the first OFDM signals, and to transmit the second OFDM signals, the antenna being formed within the case and being electrically coupled to the wireless communication circuit.

10. The integrated circuit package of claim 9, further comprising:
a package substrate electrically coupled via conductive bumps to a surface of the at least one integrated circuit.

11. A flip chip ball grid array package comprising the integrated circuit package of claim 10.

12. The integrated circuit package of claim 9, wherein the at least one integrated circuit comprises:
a first integrated circuit comprising a media access controller and baseband circuit; and
a second integrated circuit comprising a physical-layer device.

13. The integrated circuit package of claim 9, wherein the wireless communication circuit comprises:
a receive circuit to produce first baseband signals based on first RF signals received by the antenna; and
a transmit circuit to produce second RF signals based on second baseband signals, wherein the second RF signals are transmitted by the antenna.

14. The integrated circuit package of claim 13, wherein the first baseband signals comprise first digital data; and
wherein the second baseband signals comprise second digital data.

15. The integrated circuit package of claim 13, wherein the antenna has a length that is a vulgar fraction of a wavelength of the first and second RF signals.

16. The integrated circuit package of claim 9, wherein the wireless communication circuit is compliant with at least one standard selected from the group consisting of IEEE standards 802.11, 802.11 a, 802.11 b, 802.11g, 802.11n, 802.16, and 802.20.

## Patentansprüche

1. Integrierte Schaltungspackung zum Anschluss auf eine Leiterplatte, umfassend:
mindestens eine integrierte Schaltung (712) umfassend eine drahtlose Kommunikationsschaltung, umfassend
einen OFDM-Demodulator (Orthogonal Frequency-Division Multiplexing) zum Erzeugen von ersten digitalen Daten basierend auf den ersten OFDM-Signalen, und
einen OFDM-Modulator zum Erzeugen von zweiten OFDM-Signalen basierend auf zweiten digitalen Daten; und
ein Packungssubstrat (726), das elektrisch mit der mindestens eine integrierten Schaltung verbunden ist, wobei das Packungssubstrat eine Antenne (715) umfasst, um die ersten OFDM-Signale zu empfangen und die zweiten OFDM-Signale zu senden, wobei die Antenne in dem Packungssubstrat ausgebildet und elektrisch mit der drahtlosen Kommunikationsschaltung verbunden ist.

2. Integrierte Schaltungspackung nach Anspruch 1, wobei das Packungssubstrat elektrisch über leitfähige Kontakthöcker mit einer Oberfläche der mindestens einen integrierten Schaltung verbunden ist.

3. Flip-Chip-Kugelgitteranordnungspackung, umfassend die integrierte Schaltungspackung nach Anspruch 1.

4. Integrierte Schaltungspackung nach Anspruch 1, wobei die mindestens eine integrierte Schaltung umfasst: eine erste integrierte Schaltung, umfassend eine Medienzugriffssteuerung und eine Basisbandschaltung; und eine zweite integrierte Schaltung, umfassend eine Bitübertragungsschichtvorrichtung.

5. Integrierte Schaltungspackung nach Anspruch 1, wobei die drahtlose Kommunikationsschaltung umfasst:
eine Empfangsschaltung zum Erzeugen von ersten Basisbandsignalen basierend auf ersten HF-Signalen, die von der Antenne empfangen werden; und
eine Sendeschaltung zum Erzeugen von zweiten HF-Signalen basierend auf zweiten Basisbandsignalen, wobei die zweiten HF-Signale durch die Antenne gesendet werden.

6. Integrierte Schaltungspackung nach Anspruch 5, wobei die ersten Basisbandsignale erste digitale Daten umfassen; und
wobei die zweiten Basisbandsignale zweite digitale Daten umfassen.

7. Integrierte Schaltungspackung nach Anspruch 5, wobei die Antenne eine Länge aufweist, die ein gemeiner Bruch einer Wellenlänge der ersten und zweiten HF-Signale ist.

8. Integrierte Schaltungspackung nach Anspruch 1, wobei die drahtlose Kommunikationsschaltung mindestens einen Standard erfüllt, der aus der Gruppe gewählt wird, die aus den IEEE-Standards 802.11, 802.11a, 802.11b, 802.11g, 802.11n, 802.16 und 802.20 besteht.

9. Integrierte Schaltungspackung, umfassend:
mindestens eine integrierte Schaltung (912) umfassend eine drahtlose Kommunikationsschaltung, umfassend
einen OFDM-Demodulator (Orthogonal Frequency-Division Multiplexing) zum Erzeugen von ersten digitalen Daten basierend auf den ersten OFDM-Signalen, und
einen OFDM-Modulator zum Erzeugen von zweiten OFDM-Signalen basierend auf zweiten digitalen Daten; und
ein Gehäuse (922), umfassend eine Antenne (915), um die ersten OFDM-Signale zu empfangen und die zweiten OFDM-Signale zu senden, wobei die Antenne in dem Gehäuse ausgebildet und elektrisch mit der drahtlosen Kommunikationsschaltung verbunden ist.

10. Integrierte Schaltungspackung nach Anspruch 9, des Weiteren umfassend:
ein Packungssubstrat, das elektrisch über leitfähige Kontakthöcker mit einer Oberfläche der mindestens einen integrierten Schaltung verbunden ist.

11. Flip-Chip-Kugelgitteranordnungspackung, umfassend die integrierte Schaltungspackung nach Anspruch 10.

12. Integrierte Schaltungspackung nach Anspruch 9, wobei die mindestens eine integrierte Schaltung umfasst:
eine erste integrierte Schaltung, umfassend eine Medienzugriffssteuerung und eine Basisbandschaltung; und
eine zweite integrierte Schaltung, umfassend eine Bitübertragungsschichtvorrichtung.

13. Integrierte Schaltungspackung nach Anspruch 9, wobei die drahtlose Kommunikationsschaltung umfasst:
eine Empfangsschaltung zum Erzeugen von ersten Basisbandsignalen basierend auf ersten HF-Signalen, die von der Antenne empfangen werden; und
eine Sendeschaltung zum Erzeugen von zweiten HF-Signalen basierend auf zweiten Basisbandsignalen, wobei die zweiten HF-Signale durch die Antenne gesendet werden.

14. Integrierte Schaltungspackung nach Anspruch 13, wobei die ersten Basisbandsignale erste digitale Daten umfassen; und
wobei die zweiten Basisbandsignale zweite digitale Daten umfassen.

15. Integrierte Schaltungspackung nach Anspruch 13, wobei die Antenne eine Länge aufweist, die ein gemeiner Bruch einer Wellenlänge der ersten und zweiten HS-Signale ist.

16. Integrierte Schaltungspackung nach Anspruch 9, wobei die drahtlose Kommunikationsschaltung mindestens einen Standard erfüllt, der aus der Gruppe gewählt wird, die aus den IEEE-Standards 802.11, 802.11a, 802.11b, 802.11g, 802.11n, 802.16 und 802.20 besteht.

## Revendications

1. Boîtier de circuit intégré destiné à être relié à une carte à circuit imprimé comprenant :
au moins un circuit intégré (712) comprenant un circuit de communication sans fil, comprenant :
un démodulateur à multiplexage par répartition orthogonale de la fréquence, OFDM, destiné à générer des premières données numériques fondées sur des premiers signaux de modulation OFDM, et
un modulateur OFDM destiné à générer des seconds signaux de modulation OFDM sur la base de secondes données numériques, et
un substrat de boîtier (726) couplé électriquement à ce ou à ces circuits intégrés, le substrat de boîtier comprenant une antenne (715) destinée à recevoir les premiers signaux de modulation OFDM et à transmettre les seconds signaux de modulation OFDM, l'antenne étant formée à l'intérieur du substrat de boîtier et étant couplée électriquement au circuit de communication sans fil.

2. Boîtier de circuit intégré selon la revendication 1, dans lequel le substrat de boîtier est couplé électriquement par l'intermédiaire de plots conducteurs à une surface du ou des circuits intégrés.

3. Boîtier de circuit intégré selon la revendication 1, comprenant le boîtier de circuit intégré conforme à la revendication 1.

4. Boîtier de circuit intégré selon la revendication 1, dans lequel le ou les circuits intégrés comprennent : un premier circuit intégré comprenant un contrôleur d'accès au support et un circuit en bande de base, ainsi qu'un second circuit intégré comprenant un composant de couche physique.

5. Boîtier de circuit intégré selon la revendication 1, dans lequel le circuit de communication sans fil comprend :
un circuit de réception destiné à générer des premiers signaux en bande de base fondés sur des premiers signaux RF reçus par l'antenne, et
un circuit d'émission destiné à générer des seconds signaux RF fondés sur des seconds signaux en bande de base, les seconds signaux RF étant transmis par l'antenne.

6. Boîtier de circuit intégré selon la revendication 5, dans lequel les premiers signaux en bande de base comprennent des premières données numériques, et
dans lequel les seconds signaux en bande de base comprennent des secondes données numériques.

7. Boîtier de circuit intégré selon la revendication 5, dans lequel l'antenne présente une longueur qui est une fraction décimale d'une longueur d'onde des premiers et des seconds signaux RF.

8. Boîtier de circuit intégré selon la revendication 1, dans lequel le circuit de communication sans fil est conforme à au moins une norme sélectionnée à partir du groupe constitué des normes IEEE 802.11, 802.11a, 802.11b, 802.11g, 802.11n, 802.16 et 802.20.

9. Boîtier de circuit intégré comprenant :
au moins un circuit intégré (912) comprenant un circuit de communication sans fil comprenant :
un démodulateur à multiplexage par répartition orthogonale de la fréquence, OFDM, destiné à générer des premières données numériques fondées sur des premiers signaux de modulation OFDM, et
un modulateur OFDM destiné à générer des seconds signaux de modulation OFDM fondés sur des secondes données numériques, et
un boîtier (922) comprenant une antenne (915) destinée à recevoir les premiers signaux de modulation OFDM et à transmettre les seconds signaux de modulation OFDM, l'antenne étant formée à l'intérieur du boîtier et étant couplée électriquement au circuit de communication sans fil.

10. Boîtier de circuit intégré selon la revendication 9, comprenant en outre :
un substrat de boîtier couplé électriquement par l'intermédiaire de plots conducteurs à une surface du ou des circuits intégrés.

11. Boîtier matriciel à billes de type puce retournée comprenant le boîtier de circuit intégré conforme à la revendication 10.

12. Boîtier de circuit intégré selon la revendication 9, ou un dans lequel le ou les circuits intégrés comprennent :
un premier circuit intégré comprenant un contrôleur d'accès au support et un circuit en bande de base, et
un second circuit intégré comprenant un composant de couche physique.

13. Boîtier de circuit intégré selon la revendication 9, dans lequel le circuit de communication sans fil comprend :
un circuit de réception destiné à générer des premiers signaux en bande de base fondés sur des premiers signaux RF reçus par l'antenne, et
un circuit d'émission destiné à générer des seconds signaux RF fondés sur des seconds signaux en bande de base, les seconds signaux RF étant transmis par l'antenne.

14. Boîtier de circuit intégré selon la revendication 13, dans lequel les premiers signaux en bande de base comprennent des premières données numériques, et
dans lequel les seconds signaux en bande de base comprennent des secondes données numériques.

15. Boîtier de circuit intégré selon la revendication 13, dans lequel l'antenne présente une longueur qui est une fraction décimale d'une longueur d'onde des premiers et des seconds signaux RF.

16. Boîtier de circuit intégré selon la revendication 9, dans lequel le circuit de communication sans fil est conforme à au moins une norme sélectionnée à partir du groupe constitué des normes IEEE 802.11, 802.11a, 802.11b, 802.11g, 802.11n, 802.16 et 802.20.
